# EUROPEAN PATENT SPECIFICATION

(11) **EP 2 019 333 B1**
(45) Date of publication and mention of the grant of the patent: **06.04.2011**
(21) Application number: 07113132.0
(22) Date of filing: 25.07.2007
(51) Int. Cl.: G03F 7/00, G11B 7/26

(54) **Production of stamps, masks or templates for semiconductor device manufacturing**
Herstellung von Stempeln, Masken und Schablonen zur Herstellung von Halbleiterbauelementen
Production de timbres, masques ou modèles pour la fabrication de dispositifs semiconducteurs

(43) Date of publication of application: 28.01.2009
(73) Proprietor: Singulus Mastering B.V., 5657 EN Eindhoven (NL)
(72) Inventor: Franse, Jelm, 5657 EN Eindhoven (NL)
(74) Representative: Vossius & Partner

(56) References cited:
- EP-A- 0 355 925
- WO-A-03/042985
- WO-A-2006/045332
- JP-A- 4 095 243
- JP-A- 7 014 218
- JP-A- 7 320 305
- US-A1- 2006 286 355
- US-B1- 6 638 692

## Description

The present invention relates to a method for manufacturing a substrate for semiconductor device manufacturing and to a method for producing a set of stamps or masks, also called templates using a mastering process.

In a semiconductor manufacturing processes such as embossing, imprint or optical lithography, multiple patterned layers are stacked on a substrate by repeatedly applying the basic process steps. For a proper functioning of the created device accurate overlay in successive process steps is essential. This is often achieved by incorporating alignment marks in the masks or stamps used in consecutive process steps and correlating the position of the mask/stamp to similar features left on the substrate/device in previous steps.

For forming the structure on a stamp or a mask, equipment and processes known from the production of master discs for optical media may be used. Typically, the production of a master disc comprises the steps of cleaning a substrate, e.g. a glass substrate, and applying a layer of a radiation sensitive material to a surface of the substrate, illuminating the sensitive material on the substrate in a desired pattern by moving a focused laser spot over the substrate, and developing the layer of sensitive material. The sensitive material may be a photo-sensitive material or a phase transition layer. Writing of the information on the disc by illuminating the layer of radiation sensitive material in a predetermined pattern is usually done in a laser beam recorder. For most optical media, a spiral or concentric circles are recorded with pits and/or grooves by rotating the substrate and translating the laser spot radially relative with respect to the substrate. With the present laser beam recorders, radial positional accuracies of less than 10 nm can be achieved as well as very accurate tangential positions.

A method of manufacturing a stamp for use in the manufacture of small form factor (SFF) optical data storage media is known from WO 03/042985 A2 wherein on a single master plate a series of areas with spiral- or concentric-shaped information tracks is provided, with the center of each area located outside the axis of rotation of the master plate. The different areas are written one after the other on the master plate by fixing the master plate eccentrically with respect to an axis of rotation of a support structure and rotating the support structure with the attached master plate around the axis of rotation of the support structure. The stamp obtained from the thus produced master plate may be used to simultaneously produce a number of replicas corresponding to the areas on the master plate.

When in the production of a semiconductor device several layers subsequently have to be formed on top of each other on the same substrate, correct alignment of the different templates used for forming the structures in the different layers is very important. Therefore, a high relative positional accuracy of the structures on the different stamps or masks has to be guaranteed.

It is therefore an object of the invention to provide a method for manufacturing a substrate with structures in different areas thereon, with these areas having a very high relative positional accuracy, that is, the patters in the different areas should be very good references with respect to each other. It is further an object of the invention to provide a method for manufacturing a set of stamps or masks for manufacturing semiconductor devices using the substrate. It should be possible to align the different stamps or masks with a high accuracy in subsequent process steps.

These objects are achieved with the features of the claims.

The present invention is based on the idea to write the structures in different areas of one substrate using known mastering equipment. The structures in the different areas may be structures of different stamps or masks used for manufacturing semiconductor devices. Optionally, one or more alignment marks may be formed in each of the areas at the same relative positions. The structures in the different areas arranged on one substrate are recorded in one single sweep in a laser beam recorder. This may be done by spirally moving the laser spot, or by moving the laser spot in a concentric circle and by changing the radius of the circle in a stepwise manner in order to move the laser spot over the entire substrate. Since track pitch control and rotation control are extremely good, the patterns in the different areas, preferably corresponding to the different stamps or masks, are very good references with respect to each other. For example, if the different areas are circularly arranged on the substrate, recording of all areas starts exactly at the same radius, and thus, the position of the written structures and, if applicable, the alignment marks, are determined with a very high relative position accuracy. By manufacturing a set of masks or stamps to be used in successive process steps in one run of a laser beam or e-beam (electron beam) recorder (LBR) such as used to create masters for optical recording, a coherent mask or stamp set with very good alignment positions can be created.

The structures in the different areas may have any desired pattern and need not be circular structured but may have a structure in the x-y directions, for example a pattern having rows and columns. Since the structure is written according to the present invention by circularly moving the laser spot over the substrate, it may be necessary to make a coordinate transformation of the data to be written on the substrate using a software program. Furthermore, the areas may have any desired shape, for example circular or rectangular.

In order to prepare the templates, that is the stamps or masks, the different areas on the substrate are separated so that the templates are obtained in the form of patterned substrate elements.

For writing the structures in the mastering equipment, any known method may be used. Accordingly, the layer of radiation sensitive material applied to the substrate may be a photo-sensitive layer, i.e., a photoresist layer or a layer of phase transition material. In the latter case, the heat-induced phase transition is caused in the sensitive material in accordance with the structure to be formed, for example by applying laser pulses. An example for a material sensitive for phase transitions is ZnS-SiOₓ.

In the following, the present invention is described in more detail with reference to the drawings.
- Fig. 1: schematically shows the arrangement of the structures of four stamps arranged on a single substrate manufactured using the method according to the invention.
- Fig. 2: shows a SEM micrograph of a structure with a detail of the mask and the marker.

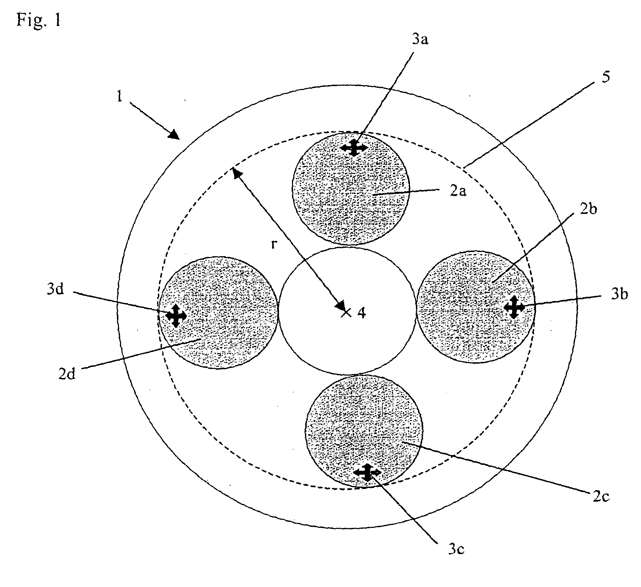

Fig. 1 illustrates an exemplary arrangement of four separate areas 2a to 2d on a substrate, each comprising the pattern of a stamp to be manufactured. The patterns in the different areas 2a to 2d may be the same or may be different. The substrate 1 used according to the invention may be a standard substrate, for example a glass substrate as used when producing a master for the CD or DVD production. As shown in Fig. 1, in each of the four areas 2a to 2d, an alignment mark 3a to 3d is written. Preferably, however, more than one alignment mark is written in each area in order to improve the accuracy when aligning the different stamps in the imprint lithography process.

It is preferred according to the present invention that the relative positions of the different areas 2a to 2d are positioned such that the respective structures in each area 2a to 2d have the same distance from the center 4 of the substrate, e.g., are positioned symmetrically with respect to the center 4 of the substrate 1, as shown in Fig. 1. Thus, the four areas 2a to 2d are preferably arranged on a circle on the substrate 1. With this particular arrangement, it can be achieved that writing the different areas 2a to 2d starts at the same track 5 with the same distance r from the center 4 of the substrate 1 when the information is written on the substrate 1 in the laser beam recorder. This is because the information is written by circularly moving the laser spot over the substrate 1, for example by rotating the substrate 1 around the center 4 in the laser beam recorder. Furthermore, the alignment marks 3a to 3d written in each one of the areas 2a to 2d are arranged at the same relative positions in each of the areas 2a to 2d, and, as can be seen from Fig. 1, are also symmetrical with respect to the center 4 of the substrate I. Consequently, also the boundaries of the alignment marks 3a to 3d are written starting at the same track when writing the structure on the substrate so that the relative position of the alignment marks 3a to 3d on the manufactured stamps are determined with a very high positional accuracy.

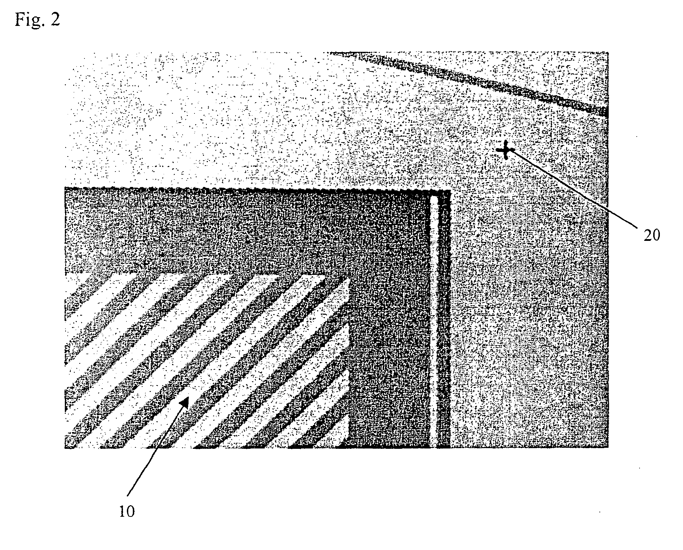

Fig. 2 shows a scanning electron microscopy (SEM) micrograph of a pattern produced using the method of the present invention. Specifically, Fig. 2 shows a corner of a rectangular structure 10 and an alignment mark 20. The alignment mark 20 in the form of an alignment cross is positioned close to the corner of the rectangular pattern 10.

## Claims

1. Method for manufacturing a substrate (1) comprising at least two areas (2a to 2d) with the same or different pattern(s) on the surface of the substrate for manufacturing of semiconductor devices, said method comprising the steps of:
(a) providing the substrate (1);
(b) applying a layer of a radiation sensitive material on the substrate (1);
(c) recording the pattern(s) of the at least two areas (2a to 2d) in the layer of radiation sensitive material and
(d) developing the layer of radiation sensitive material,
**characterized in that** recording the pattern(s) in step (c) is performed by moving a focused recording spot in one sweep over the entire substrate (1).

2. Method according to claim 1, wherein the recording spot is moved over the entire substrate (1) along a spiral or along concentric circles while successively changing the radius of the circles.

3. Method according to claim 1 or 2, wherein the recording spot is a focused laser beam spot or a focussed electron beam spot.

4. Method according to claim 1, 2 or 3, wherein the pattern(s) correspond to structures of at least two stamps or masks.

5. Method according to any one of the preceding claims, wherein the radiation sensitive material is a photo-sensitive material or a material sensitive to heat such as for example a phase transition material.

6. Method according to any one of the preceding claims, wherein the different areas (2a to 2d) are arranged on the substrate (1) on a circle.

7. Method according to any one of the preceding claims, wherein at least one alignment mark (3a to 3d) is recorded in each one of the different areas (2a to 2d), corresponding alignment marks (3a to 3d) are formed at the same relative positions in each of the areas (2a to 2d).

8. Method according to claim 7, wherein the corresponding alignment marks (3a to 3d) in each one of the different areas (2a to 2d) have the same radial position on the substrate (1).

9. Method for manufacturing at least two stamps or masks for manufacturing of semiconductor devices using a mastering process, the method comprising the steps of:
(a) manufacturing a substrate (1) with the method according to any one of the preceding claims; and
(b) separating the at least two areas (2a to 2d) of the substrate (1) to obtain the at least two stamps or masks in the form of patterned substrate elements.

## Patentansprüche

1. Verfahren zum Herstellen eines Substrats (1) mit mindestens zwei Bereichen (2a-2d) mit dem gleichen Muster oder verschiedenen Mustern auf der Oberfläche des Substrats zum Herstellen von Halbleiterelementen, mit den folgenden Verfahrensschritten:
(a) Bereitstellen des Substrats (1),
(b) Aufbringen einer Schicht von strahlungsempfindlichem Material auf dem Substrat (1),
(c) Aufzeichnen des Musters bzw. der Muster der mindestens zwei Bereiche (2a-2d) in der Schicht aus strahlungsempfindlichem Material, und
(d) Entwickeln der Schicht aus strahlungsempfindlichem Material,
**dadurch gekennzeichnet, dass** das Aufzeichnen des Musters bzw. der Muster im Schritt (c) durch Bewegen eines fokussierten Aufzeichnungsflecks in einem Schwenk über das gesamte Substrat (1) ausgeführt wird.

2. Verfahren nach Anspruch 1, wobei der Aufzeichnungsfleck über das gesamte Substrat (1) entlang einer Spirale oder entlang konzentrischer Kreise bewegt wird, während aufeinander folgend der Radius der Kreise geändert wird.

3. Verfahren nach Anspruch 1 oder 2, wobei der Aufzeichnungsfleck ein fokussierter Laserstrahlfleck oder ein fokussierter Elektronenstrahlfleck ist.

4. Verfahren nach Anspruch 1, 2 oder 3, wobei das Muster bzw. die Muster den Strukturen von mindestens zwei Stempeln oder Masken entsprechen.

5. Verfahren nach einem der vorstehenden Ansprüche, wobei das strahlungsempfindliche Material ein lichtempfindliches Material oder ein wärmeempfindliches Material, beispielsweise ein Phasenübergangsmaterial ist.

6. Verfahren nach einem der vorstehenden Ansprüche, wobei die verschiedenen Bereiche (2a-2d) auf dem Substrat (1) auf einem Kreis angeordnet sind.

7. Verfahren nach einem der vorstehenden Ansprüche, wobei mindestens eine Richtmarke (3a-3d) in jedem der verschiedenen Bereiche (2a-2d) aufgezeichnet ist, wobei entsprechende Richtmarken (3a-3d) an den selben relativen Positionen in jedem der Bereiche (2a-2d) ausgebildet sind.

8. Verfahren nach Anspruch 7, wobei die entsprechenden Richtmarken (3a-3d) in jeder der verschiedenen Bereiche (2a-2d) die gleiche radiale Position auf dem Substrat (1) haben.

9. Verfahren zum Herstellen von mindestens zwei Stempeln oder Masken zum Herstellen von Halbleiterelementen unter Anwendung eines Masteringprozesses, wobei das Verfahren die folgenden Schritte aufweist:
(a) Herstellen eines Substrats (1) mit dem Verfahren nach einem der vorstehenden Ansprüche und
(b) Trennen der mindestens zwei Bereiche (2a-2d) des Substrats (1), um mindestens zwei Stempel oder Masken in der Form bemusterter Substratelemente zu erhalten.

## Revendications

1. Procédé de fabrication d'un substrat (1) comprenant au moins deux zones (2a à 2d) avec le même motif ou des motifs différents à la surface du substrat, pour la fabrication de dispositifs semi-conducteurs, ledit procédé comprenant les étapes de :
(a) réalisation du substrat (1) ;
(b) application sur le substrat (1) d'une couche d'un matériau sensible aux radiations ;
(c) gravure du ou des motifs des deux zones au moins (2a à 2d) dans la couche de matériau sensible aux radiations, et
(d) développement de la couche de matériau sensible aux radiations
**caractérisé en ce que** la gravure du ou des motifs en étape (c) est exécuté par déplacement d'un spot de gravure focalisé en un seul mouvement de balayage sur l'ensemble du substrat (1).

2. Procédé selon la revendication 1, où le spot de gravure est déplacé sur l'ensemble du substrat (1) le long d'une spirale ou le long de cercles concentriques en modifiant successivement le rayon des cercles.

3. Procédé selon la revendication 1 ou la revendication 2, où le spot de gravure est un spot de faisceau laser focalisé ou un spot de faisceau électronique focalisé.

4. Procédé selon la revendication 1, la revendication 2 ou la revendication 3, où le ou les motifs correspondent aux structures d'au moins deux timbres ou masques.

5. Procédé selon l'une quelconque des revendications précédentes, où le matériau sensible aux radiations est un matériau photosensible ou un matériau sensible à la chaleur tel qu'un matériau à transition de phase.

6. Procédé selon l'une quelconque des revendications précédentes, où les différentes zones (2a à 2d) sont disposées en cercle sur le substrat (1).

7. Procédé selon l'une quelconque des revendications précédentes, où au moins un repère d'alignement (3a à 3d) est gravé sur chacune des différentes zones (2a à 2d), des repères d'alignement correspondants (3a à 3d) étant formés aux mêmes emplacements relatifs dans chacune des zones (2a à 2d).

8. Procédé selon la revendication 7, où les repères d'alignement correspondants (3a à 3d) dans chacune des différentes zones (2a à 2d) ont la même position radiale sur le substrat (1).

9. Procédé de fabrication d'au moins deux timbres ou masques pour la fabrication de dispositifs semi-conducteurs, recourant à un processus de gravure, ledit procédé comprenant les étapes de :
(a) fabrication d'un substrat (1) au moyen du procédé selon l'une quelconque des revendications précédentes ; et
(b) séparation des deux zones au moins (2a à 2d) du substrat (1) afin d'obtenir les deux timbres ou masques au moins sous la forme d'éléments de substrat à motif.
